Europäisches Patentamt

European Patent Office

Office européen des brevets

(19)

(11) Numéro de publication: **0 066 326**
**A1**

(12) # DEMANDE DE BREVET EUROPEEN

(21) Numéro de dépôt: 82200598.9

(22) Date de dépôt: 17.05.82

(51) Int. Cl.³: **H 01 P 1/203**
**H 03 F 3/60**

(30) Priorité: 27.05.81 FR 8110571

(43) Date de publication de la demande:
08.12.82 Bulletin 82/49

(84) Etats contractants désignés:
BE DE FR GB IT SE

(71) Demandeur: Laboratoires d'Electronique et de
Physique Appliquee L.E.P.
3, Avenue Descartes
F-94450 Limeil-Brevannes(FR)

(84) Etats contractants désignés:
FR

(71) Demandeur: N.V. Philips' Gloeilampenfabrieken
Groenewoudseweg 1
NL-5621 BA Eindhoven(NL)

(84) Etats contractants désignés:
BE DE GB IT SE

(72) Inventeur: de Ronde, François
Société Civile S.P.I.D. 209 rue de l'Université
F-75007 Paris(FR)

(74) Mandataire: Landousy, Christian et al,
Société Civile S.P.I.D. 209, Rue de l'Université
F-75007 Paris(FR)

(54) Dispositif de polarisation d'éléments actifs hyperfréquences.

(57) Dispositif de polarisation d'éléments actifs hyperfréquences et notamment de transistors à effet de champ,
composé d'un circuit d'alimentation destiné à fournir, par
l'intermédiaire d'un tronçon (4) de ligne de transmission
interposé entre ce circuit et une ligne principale de transmission (1) et présentant en son point de raccordement (6) avec
celle-ci une impédance suffisamment élevée pour interdire la
transmission du signal hyperfréquence utile parcourant la
ligne principale (1) vers le circuit d'alimentation tout en
autorisant la transmission du courant continu délivré par ce
circuit, un courant continu de polarisation à un élément actif
hyperfréquence placé en série sur la ligne principale de
transmission. Ce dispositif comprend un filtre, passe-bande
vis-à-vis du signal hyperfréquence utile et composé de deux
rubans conducteurs (11) et (12) qui sont raccordés en
parallèle sur la ligne principale de transmission (1), symétriquement de part et d'autre du point de raccordement (6) du
tronçon de ligne à la ligne principale. Ces rubans sont situés
à une distance de ce point (6) égale environ au quart de la
longueur d'onde du signal hyperfréquence utile.

Application: polarisation de tous éléments actifs hyperfréquences et notamment de ceux des systèmes de réception
de télévision transmise par satellites.

FIG.2

Croydon Printing Company Ltd

DISPOSITIF DE POLARISATION D'ELEMENTS ACTIFS HYPERFREQUENCES

La présente invention a trait à un dispositif de polarisation d'éléments actifs hyperfréquences tels que diodes ou transistors, et notamment de transistors à effet de champ, réalisé en structure plane selon la technique du circuit imprimé associé à un support diélectrique.

On connaît déjà, d'après le brevet des Etats-Unis d'Amérique N° 4 023 125 déposé le 17 octobre 1975 par la Société cessionnaire General Electric Company et délivré le 10 mai 1977, des circuits de polarisation d'éléments hyperfréquences qui comprennent un tronçon de ligne de transmission présentant une haute impédance à son point de raccordement avec la ligne de transmission principale parcourue par le signal hyperfréquence utile. Dans ces circuits, l'accroissement de bande passante est recherché à l'aide d'une chaîne de segments de lignes de transmission reliés en série, ce qui d'une part conduit à un dispositif relativement encombrant et d'autre part n'empêche pas que des réflexions parasites prennent une importance croissante dès qu'on s'éloigne de la fréquence de résonance du tronçon de ligne de transmission.

Le but de l'invention est de proposer un dispositif de polarisation tel que défini plus haut, et qui soit à la fois très compact et à large bande de fréquence.

L'invention concerne à cet effet un dispositif de polarisation d'éléments actifs hyperfréquences réalisé en structure plane selon la technique du circuit imprimé associé à un support diélectrique et comprenant un circuit d'alimentation destiné à fournir, par l'intermédiaire d'un tronçon de ligne de transmission interposé entre ce circuit et une ligne principale de transmission et présentant en son point de raccordement avec celle-ci une impédance suffisamment élevée pour interdire la transmission du signal hyperfréquence utile parcourant la ligne principale vers le circuit d'alimentation tout en autorisant la transmission du courant continu délivré par ce circuit, un courant continu de polarisation à un élément actif hyperfréquence placé en série sur la ligne principale de transmission, caractérisé en ce qu'il comprend un dispositif de filtrage du type passe-bande vis-à-vis du signal hyperfréquence utile, composé de deux rubans conducteurs qui sont raccordés en parallèle sur la ligne principale de transmission, symétriquement de part et d'autre du point de raccordement du tronçon de ligne à la ligne principale, et qui sont situés à une distance de ce point égale environ au huitième de la longueur d'onde du signal hyperfréquence utile.

Avec la structure ainsi proposée, les réflexions qui se produisent sur les deux rubans conducteurs s'annulent mutuellement lorsqu'on se trouve à la fréquence utile, puisqu'elles sont égales en amplitude et de sens opposé. Aux fréquences inférieures à cette fréquence utile, les réflexions résiduelles dues aux rubans conducteurs, qui sont capacitifs, compensent, par un choix approprié des valeurs des capacités de ces rubans, les réflexions dues au tronçon de ligne de transmission (qui, lui, est de nature inductive au-dessous de la fréquence utile). Cette compensation reste efficace sur une bande de fréquence importante, nettement supérieure à une octave.

Les particularités et avantages de l'invention seront maintenant précisés en se référant à la description qui suit et aux dessins annexés qui montrent, à titre d'exemple non limitatif, un mode de réalisation de l'invention et dans lesquels :

- la figure 1 montre un mode de réalisation de dispositif de polarisation conforme à l'art antérieur connu ; et

- la figure 2 est une vue agrandie d'une partie de la figure 1, sur laquelle sont représentés les éléments originaux d'un dispositif de polarisation conforme à l'invention.

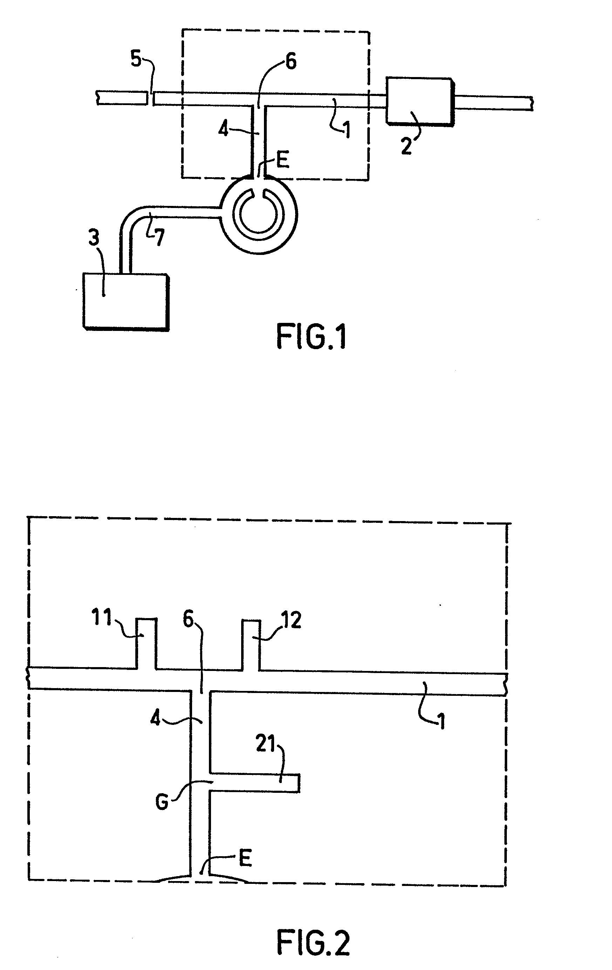

Un exemple de dispositif de polarisation selon l'art antérieur est représenté sur la figure 1 et comprend une ligne principale 1 de transmission hyperfréquence sur laquelle est prévu, en série, un transistor à effet de champ 2. Un circuit d'alimentation 3 fournit au transistor 2 sa tension de polarisation, par l'intermédiaire d'un tronçon 4 de ligne de transmission interposé entre ce circuit 3 et la ligne principale 1. Le tronçon de ligne 4 présente en son point de raccordement 6 à la ligne principale 1 une impédance élevée qui, tout en autorisant l'envoi de la tension de polarisation vers le transistor 2, empêche la dérivation du signal hyperfréquence utile parcourant la ligne 1 vers le circuit d'alimentation 3. Dans le cas présent, cette impédance élevée est obtenue en donnant au tronçon de ligne 4 une longueur égale au quart de la longueur d'onde du signal hyperfréquence utile et en prévoyant entre la connexion de sortie 7 du circuit d'alimentation 3 et l'extrémité E de ce tronçon 4 un dispositif qui permet de définir au point E, de façon unique et précise, un plan de court-circuit et donc de ramener au point 6, à l'autre extrémité du tronçon 4, une impédance de valeur très élevée. Un élément capacitif 5 est mis en place sur la ligne principale 1 pour interdire le passage du courant de polarisation dans la direction opposée à celle du transistor.

Selon l'invention, le dispositif de polarisation décrit ci-dessus comprend en outre, comme le montre la figure 2 qui est une vue agrandie d'une partie de la figure 1 et qui met en évidence les éléments originaux de ce dispositif, un filtre passe-bande vis-à-vis du signal hyperfréquence utile, composé de deux rubans conducteurs 11 et 12 raccordés en parallèle sur la ligne principale 1. Ces rubans, placés symétriquement de part et d'autre du point 6 de raccordement du tronçon de ligne 4 à la ligne 1, sont situés à une distance de ce point 6 égale au huitième de la longueur d'onde du signal hyperfréquence utile, de sorte qu'à la fréquence utile les réflexions du signal se produisant sur l'un s'annulent exactement avec celles, égales en amplitude mais de signe opposé, qui se produisent sur l'autre. Aux fréquences inférieures à cette fréquence, les rubans 11 et 12 sont toujours la cause de réflexions, mais qui ne s'annulent plus. Cependant, comme ces rubans sont capacitifs, la valeur de leurs capacités peut être choisie de façon à compenser sur une large bande de fréquences -plus d'une octave- l'effet inductif du tronçon de ligne de transmission (en effet, le tronçon $\lambda/4$ de ligne de transmission est assimilable à une inductance au-dessous de la fréquence utile, à un condensateur au-delà).

Un circuit quart d'onde 21 peut être placé en parallèle sur le tronçon de ligne 4 pour constituer avec celui-ci une charge capable, par l'impédance que ce circuit ramène au point de raccordement 6 lorsqu'on se trouve à une fréquence double de la fréquence utile, d'éviter la présence d'un court-circuit en ce point 6 (ce qui serait le cas en l'absence du circuit 21, pour cette fréquence double). Ce circuit 21 est un ruban conducteur de longueur égale au quart de la longueur d'onde associée à ladite fréquence double (c'est-à-dire au huitième de la longueur d'onde du signal hyperfréquence utile) et raccordé au tronçon 4 en un point G situé à une distance de 6 égale aussi au quart de la longueur d'onde associée à ladite fréquence double (c'est-à-dire en un point G situé à mi-longueur du tronçon 4).

Bien entendu, la présente invention n'est pas limitée à l'exemple de réalisation décrit et représenté, à partir duquel des variantes pourraient être proposées sans pour cela sortir du cadre ou de l'esprit de l'invention.

REVENDICATIONS :

1.  Dispositif de polarisation d'éléments actifs hyperfréquences réalisé en structure plane selon la technique du circuit imprimé associé à un support diélectrique et comprenant un circuit d'alimentation destiné à fournir, par l'intermédiaire d'un tronçon (4) de
ligne de transmission interposé entre ce circuit et une ligne principale
de transmission (1) et présentant en son point de raccordement (6)
avec celle-ci une impédance suffisamment élevée pour interdire la transmission du signal hyperfréquence utile parcourant la ligne principale
(1) vers le circuit d'alimentation tout en autorisant la transmission du
courant continu délivré par ce circuit, un courant continu de polarisation à un élément actif hyperfréquence placé en série sur la ligne principale de transmission, caractérisé en ce qu'il comprend un dispositif
de filtrage du type passe-bande vis-à-vis du signal hyperfréquence utile,
composé de deux rubans conducteurs (11) et (12) qui sont raccordés en
parallèle sur la ligne principale de transmission (1), symétriquement
de part et d'autre du point de raccordement (6) du tronçon de ligne à
la ligne principale, et qui sont situés à une distance de ce point (6)
égale environ au huitième de la longueur d'onde du signal hyperfréquence
utile.

2.  Dispositif selon la revendication 1, caractérisé en ce
qu'il comprend au moins un deuxième circuit (21) dit quart d'onde de
longueur égale au huitième de la longueur d'onde du signal hyperfréquence utile et placé en parallèle sur le tronçon de ligne (4) à une distance du point de raccordement (6) de ce tronçon (4) à la ligne principale (1) égale aussi au huitième de la longueur d'onde du signal hyperfréquence utile.

FIG.1

FIG.2

**Office européen des brevets**

# RAPPORT DE RECHERCHE EUROPEENNE

Numéro de la demande

EP 82 20 0598

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FUJITSU SCIENTIFIC & TECHNICAL JOURNAL, vol. 9, no. 2, juin 1973, pages 1-23, Kawasaki (JP); TATSUO KUDO et al.: "4GHz uncooled parametric amplifier". *Figure 1* | 2 | H 01 P 1/203 H 03 F 3/60 |
| A | PATENTS ABSTRACTS OF JAPAN, vol. 3, no. 102, 29 août 1979, page 57E133 & JP - A - 54 79 539 (FUJITSU K.K.) (25-06-79) *En entier* | 2 | |
| X | MICROWAVE JOURNAL, vol. 24, no. 3, mars 1981, pages 63-66, Dedham (USA); G.W.SCHREYER: "A high performance S-band radar transistor". *Figure 4* | 1 | |
| A | MICROWAVE JOURNAL, vol. 23, no. 6, juin 1980, pages 65-67, Dedham (USA); CARLOS CORREIA DA SILVA BARTOLO et al.: "Design microship oscillaters with coupled line matching". *Figure 4* | 1 | DOMAINES TECHNIQUES RECHERCHES (Int. Cl. ³) H 01 P H 03 B |
| A | US-A-4 023 125 (A.R.WOLFE) *Figure 2; colonne 5, lignes 1-40* | 1 | |

-/-

Le présent rapport de recherche a été établi pour toutes les revendications

| Lieu de la recherche | Date d'achèvement de la recherche | Examinateur |
|---|---|---|
| LA HAYE | 31-08-1982 | VAN DER PEET H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82

Office européen
des brevets

RAPPORT DE RECHERCHE EUROPEENNE

Numéro de la demande

EP 82 20 0598

Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | MICROWAVE JOURNAL, vol. 23, no. 6, juin 1980, pages 55-57, Dedham (USA); R.RUBIN et al.: "The microstrip diplexer". *Figure 10* | 1 | |
| A | IEEE TRANSACTIONS ON ELECTRON DEVICES, vol. ED-19, no. 2, février 1972, pages 291-292, New York (USA); W.R.WISSEMAN et al.: "GaAs IMPATT diodes for microstrip circuit applications". *Figure 1* | 1 | |

DOMAINES TECHNIQUES
RECHERCHES (Int. Cl. 3)

Le présent rapport de recherche a été établi pour toutes les revendications

| Lieu de la recherche | Date d'achèvement de la recherche | Examinateur |
|---|---|---|
| LA HAYE | 31-08-1982 | VAN DER PEET H. |